(19) **Europäisches Patentamt / European Patent Office / Office européen des brevets**

(11) **EP 1 476 761 B1**

(12) **FASCICULE DE BREVET EUROPEEN**

(45) Date de publication et mention
de la délivrance du brevet:
**21.11.2007 Bulletin 2007/47**

(51) Int Cl.:
***G01R 1/067*** (2006.01)

(21) Numéro de dépôt: **03742481.9**

(22) Date de dépôt: **21.01.2003**

(86) Numéro de dépôt international:
**PCT/CH2003/000043**

(87) Numéro de publication internationale:
**WO 2003/071288 (28.08.2003 Gazette 2003/35)**

(54) **ACTIONNEUR DE CONTACTS AVEC CONTRÔLE DE LA FORCE DE CONTACT**

KONTAKTBETÄTIGUNGSGLIED MIT KONTAKTKRAFTREGELUNG

CONTACT ACTUATOR WITH CONTACT FORCE CONTROL

(84) Etats contractants désignés:
**AT BE BG CH CY CZ DE DK EE ES FI FR GB GR HU IE IT LI LU MC NL PT SE SI SK TR**

(30) Priorité: **20.02.2002 CH 288022002**

(43) Date de publication de la demande:
**17.11.2004 Bulletin 2004/47**

(73) Titulaire: **ISMECA Semiconductor Holding SA
2300 La Chaux-de-Fonds (CH)**

(72) Inventeurs:
• **HEINIGER, Laurent
CH-2052 Fontainemelon (CH)**

• **FROIDEVAUX, Claude
CH-2300 La Chaux-de-Fonds (CH)**
• **PERRET, Joël
CH-2300 La Chaux-de-Fonds (CH)**
• **HOSTETTLER, Pascal
CH-2300 La Chaux-de-Fonds (CH)**

(74) Mandataire: **P&TS
Patents & Technology Surveys SA
Terreaux 7
P.O.Box 2848
2001 Neuchâtel (CH)**

(56) Documents cités:
EP-A- 0 460 911     US-A- 4 956 923
US-A- 5 850 146     US-B1- 6 344 751

## Description

La présente invention concerne un système d'actionnement de contacteur pour le test automatique de composants électroniques.

Les lignes de production de composants semiconducteurs ou les lignes d'assemblage de circuits électroniques comportent en général une ligne de traitement sur laquelle les composants électroniques subissent une succession d'opérations, dont au moins une étape de test électrique. Cette étape de test permet de contrôler le fonctionnement de chaque composant et d'éliminer tout composant défectueux, avant son conditionnement en vue de son transfert sur une autre ligne de production ou avant son intégration sur un circuit électronique, par exemple.

Pour des raisons de productivité, ces lignes de production ou d'assemblage sont entièrement automatisées et leur cadence de travail doit être maximale. Le temps d'immobilisation des composants à chaque poste de traitement dépendra du temps nécessaire à l'opération la plus lente. Ainsi, chaque opération doit être effectuée en un minimum de temps. Les opérations incluant un test électrique sont souvent parmi les plus longues, puisqu'elles requièrent l'établissement d'un contact électrique entre le composant à tester et l'appareillage de test, l'exécution du test puis la rupture du contact électrique. Le temps de test étant difficilement compressible, il est important que le temps nécessaire à l'établissement et à la rupture du contact électrique soit minimal.

Dans le cas de composants à sorties radiales, le contact électrique entre le composant à tester et l'appareillage de test est généralement établi à l'aide d'un contacteur comportant une série de lames métalliques élastiques qui sont soit appuyées sur le composant à tester en certains points de contact précis, soit arrangées par paires pour enserrer, à la manière d'une pince, un ou plusieurs points de contact du composant, comme par exemple une de ses broches. Les deux modes de contact peuvent également être combinés sur le même contacteur. Pour les composants à réseau en grille, par exemple de type « pin grid array » (PGA) ou « ball grid array » (BGA), le contacteur comprend le plus souvent une plaque de contacts métalliques disposés en regard des contacts du composants qui est appliquée contre sa surface inférieure. Les contacteurs sont totalement automatisés et intégrés à la ligne de traitement. Ils sont généralement mus par leur propre générateur de mouvement, synchronisé sur la cadence de la ligne de traitement des composants.

Les brevets US5850146, US4956923 et US6344751 illustrent par exemple diverses formes de contacteurs de composants de l'art antérieur.

La majorité des systèmes actuels utilisent, en guise de générateur de mouvement, des vérins pneumatiques. Toutefois, l'accélération de ces systèmes est limitée par leur inertie, due à la masse des pièces en mouvement et à l'emploi d'une source d'énergie pneumatique. Leur vitesse est donc limitée, en particulier sur de courtes distances. Egalement en raison des masses en mouvement, de tels systèmes sont sujets au vieillissement rapide de leur mécanisme affectant ainsi leur longévité.

De plus, le contacteur doit effectuer des mouvements précis et reproductibles. En particulier, la vitesse des lames flexibles lors de l'établissement du contact avec le composant ainsi que la force de contact doivent être parfaitement contrôlées, afin d'éviter l'endommagement du composant, tout en garantissant une bonne qualité du contact électrique. Or, la génération de mouvements précis à l'aide d'un vérin pneumatique nécessite des composants précis et donc coûteux, ainsi qu'une régulation complexe des commandes du vérin.

Un des buts de la présente invention est de proposer un système d'actionnement de contacteur de composants électroniques plus rapide que les systèmes de l'art antérieur.

Un autre but de l'invention est de proposer un système d'actionnement de contacteur de composants ayant une grande longévité grâce à une faible usure de ses pièces mécaniques.

Un autre but de la présente invention est de proposer un système d'actionnement de contacteur de composants dont les mouvements sont précis et reproductibles.

Les buts énoncés ci-dessus sont atteints par un système possédant les caractéristiques de la revendication indépendante, les variantes préférentielles du système pouvant comprendre les caractéristiques des revendications dépendantes. En particulier, le système d'actionnement selon l'invention possède, en guise de générateur de mouvement, un transducteur électromécanique linéaire. Dans une variante préférentielle, afin de compenser les imprécisions de déplacement du transducteur, le contrôle de la vitesse et la limitation de la force d'appui du contacteur sur le composant à tester est effectuée à l'aide d'un mécanisme de contrôle comportant au moins une biellette.

La présente invention sera mieux comprise à la lumière des figures 1 à 3 illustrant, à titre d'exemple explicatif mais non limitatif, la version préférentielle du système d'actionnement selon l'invention.

La figure 1 représente une vue de côté du système d'actionnement selon la version préférentielle de l'invention.

Les figures 2a et 2b représentent une vue de dessus du générateur de mouvement selon la version préférentielle de l'invention.

La figure 3 représente le principe de fonctionnement du système de contrôle de la vitesse et de la force de serrage du contacteur selon la version préférentielle de l'invention.

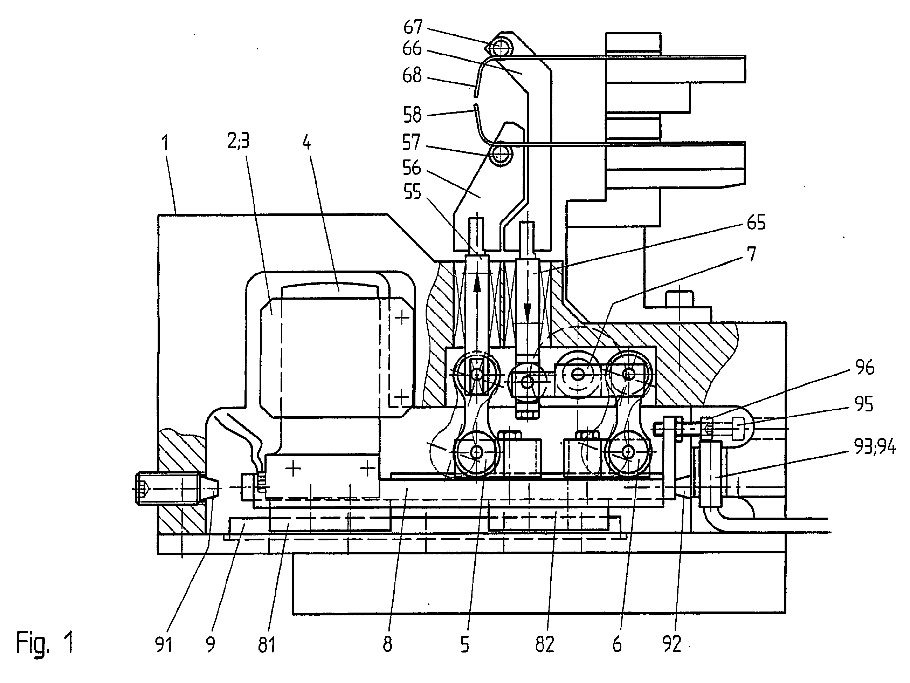

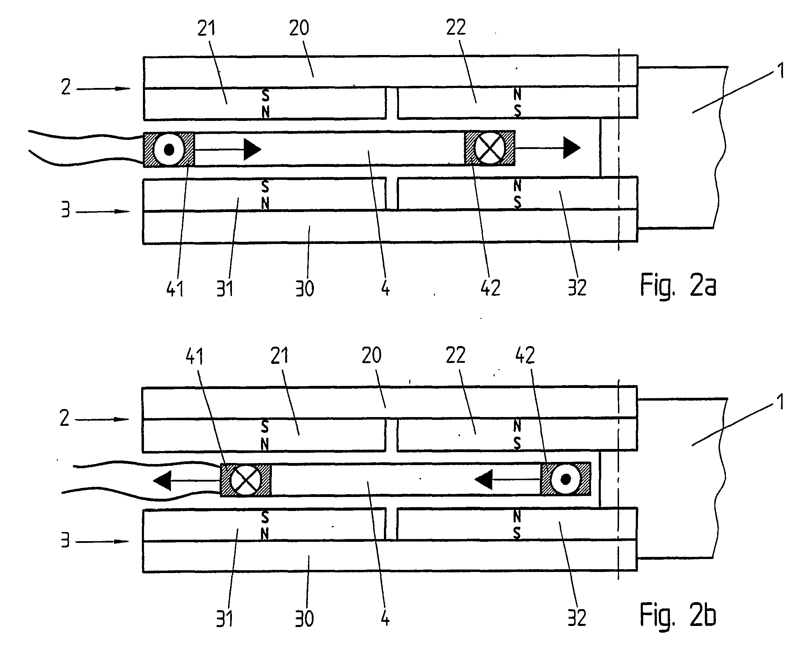

En se référant aux figures 2a et 2b, le système d'actionnement selon la version préférentielle de l'invention comprend deux blocs d'aimants permanents fixes 2, 3 liés de préférence parallèlement entre eux au châssis 1 du système. Chaque bloc d'aimants permanents 2, 3 comprend par exemple deux aimants 21, 22 et 31, 32 maintenus sur leur support 20, 30 respectif de manière à générer, dans l'espace entre les deux blocs d'aimants 2, 3, un champ magnétique dont le sens aux deux extrémités est inversé. Une bobine électrique 4 est placée entre les deux blocs d'aimants 2, 3, son axe étant globalement perpendiculaire au plan des deux blocs d'aimants 2, 3. La bobine électrique 4 est fixée sur un chariot 8 (fig. 1) maintenu et guidé par des patins 81, 82 sur des rails 9 sensiblement parallèles au plan médiateur du segment le plus court entre lesdits deux blocs d'aimants permanents 2, 3. Des butées 91, 92 sont situées de part et d'autre du chariot afin de limiter l'amplitude de ses mouvements et de déterminer ainsi deux positions discrètes du chariot 8. Le chariot 8 comporte deux marqueurs à position réglable, de préférence des vis 95, 96 à tête métallique. Lorsque le chariot 8 est dans sa première position discrète, contre la première butée 91, le premier marqueur, de préférence la tête de la première vis 95, se situe au-dessus d'un premier détecteur de position, de préférence un premier capteur inductif 93. Lorsque le chariot se trouve dans sa deuxième position discrète, contre la deuxième butée 92, le deuxième marqueur, de préférence la tête de la deuxième vis 96, se trouve au-dessus d'un deuxième détecteur de position, de préférence un deuxième capteur inductif 94.

Le contacteur illustré ici à titre d'exemple comprend deux séries de lames métalliques élastiques 58, 68 arrangées par paires et enserrant les broches du composants à tester à la manière d'une pince, dont seule la première paire est visible sur la figure 1. Le contacteur est resserré et écarté par les mouvements verticaux opposés de deux mâchoires 56, 66. Chacune des mâchoires entraîne dans son mouvement une des deux séries de lames flexibles 58, 68 par l'intermédiaire d'un cylindre 57, 67 isolé électriquement. Chaque mâchoire 56, 66 est fixée à l'extrémité supérieure d'un axe 55, 65 guidé dans un guidage vertical au travers du châssis 1.

Une première biellette 5 est liée par son axe inférieur au chariot 8 et par son axe supérieur à l'extrémité inférieure du premier axe 55. Une deuxième biellette 6 est attachée par son axe inférieur au chariot 8 et par son axe supérieur à un levier inverseur 7 sensiblement horizontal, rotatif autour d'un axe situé en son milieu. L'autre extrémité du levier inverseur 7 est lié autour d'un axe de rotation à l'extrémité inférieure du deuxième axe 65.

Dans sa version préférentielle, le transducteur électromécanique linéaire générant le mouvement du système d'actionnement selon l'invention est un moteur voice coil. Le moteur voice coil comprend les deux blocs d'aimants permanents 2, 3 et la bobine électrique mobile 4 placée entre eux et à travers laquelle un système de commande non représenté comprenant un générateur électrique peut envoyer un courant continu d'intensité et de direction variable. La bobine électrique 4 est sensiblement rectangulaire et sa dimension verticale est supérieure à celle des blocs d'aimants 2, 3. Elle est positionnée de manière à ce que les portions de spires 41, 42 placées dans le champ magnétique entre les deux blocs d'aimants 2, 3 soient verticales. Ainsi, lorsqu'un courant continu parcourt la bobine 4, le comportement de cette dernière dans le champ magnétique entre les deux blocs d'aimants 2, 3 peut être assimilé à celui de deux conducteurs électriques verticaux parcourus par un courant de même intensité mais de direction opposée et placés dans un champ magnétique de direction opposée. Chaque conducteur subit une force dans la même direction, perpendiculairement au plan formé par le sens du courant électrique et le sens du champ magnétique, dont la valeur est proportionnelle à l'intensité du courant et au flux magnétique.

Dans la version préférentielle du système d'actionnement, la direction des forces exercées sur les portions verticales 41, 42 des spires de la bobine 4 est donc parallèle aux rails 9 (Fig. 2a et 2b). La bobine va par conséquent se déplacer dans le sens de la force exercée sur elle, entraînant le chariot dans son mouvement jusqu'à ce que ce dernier soit bloqué par une des butées 91, 92.

Dans l'exemple illustré à la figure 2a, la bobine 4 se déplace ainsi jusqu'à ce que le chariot 8 atteigne sa deuxième position discrète contre la deuxième butée 92. L'inversion du courant générant une force de direction opposée sur la bobine 4 (Fig. 2b), cela provoque le retour du chariot 8 dans sa première position discrète, contre la première butée 91.

En alternant rapidement la direction du courant circulant dans la bobine 4, un mouvement de va-et-vient rapide entre les deux positions discrètes du chariot peut être généré, provoquant ainsi la fermeture et l'ouverture rapide du contacteur.

Les capteurs inductifs 93, 94 détectant la présence de la vis 95, 96 renseignent le système de contrôle sur la position du chariot 8 dans sa première ou sa deuxième position discrète, permettant la détermination du moment optimal pour le début du test ou le retour du chariot dans sa position précédente.

De préférence, la commande du système d'actionnement du contacteur selon l'invention durant un cycle de test se fait de la manière décrite ci-dessous.

Un courant de forte intensité est injecté dans la bobine afin d'amener le chariot 8 contre la deuxième butée 92 et d'ainsi fermer le contacteur sur le composant à tester. Lorsque la présence de la tête de la deuxième vis 96 est détectée par le deuxième capteur inductif 94, ce dernier transmet l'information au système d'actionnement que le contacteur est fermé. L'intensité et la direction du courant sont maintenues pendant environ 10 millisecondes après ce signal afin de plaquer fortement le chariot 8 contre la butée 92 pour amortir les vibrations du chariot 8. Passé ce délai, un courant de plus faible intensité et de même direction que le précédent est injecté à travers la bobine, générant une force suffisant au maintien du chariot 8 contre la deuxième butée 92 durant toute la durée du test.

Une fois le test terminé, un courant de forte intensité et de direction opposée au courant précédent est envoyé à travers la bobine afin d'amener le chariot 8 contre la première butée 91 et d'ainsi ouvrir le contacteur. L'élasticité des lames flexibles 58, 68 tendant à pousser le chariot dans sa position ouverte, l'intensité du courant est réduite dès que le deuxième capteur inductif 94 ne détecte plus la présence de la tête de la deuxième vis 96 afin d'éviter que le mouvement d'ouverture ne soit trop rapide. L'ouverture complète du contacteur est signalé par le premier capteur inductif 93 détectant la présence de la tête de la première vis 95. L'intensité du courant est alors à nouveau augmentée durant environ 10 millisecondes afin de plaquer fortement le chariot 8 contre la butée 91 pour amortir les vibrations du chariot 8. Passé ce délai, un courant de plus faible intensité et de même direction que le précédent est maintenu à travers la bobine, afin de générer une force maintenant le chariot 8 contre la première butée 91 jusqu'à évacuation du composant testé et présentation d'un nouveau composant devant le contacteur. Le cycle de commande est ensuite répété.

Le cycle de commande du système d'actionnement décrit plus haut est donné à titre d'exemple illustratif et non limitatif. L'homme du métier comprendra qu'il est possible de parvenir au même résultat en utilisant des courants d'intensité, de durée ou de directions diverses.

Un moteur voice coil tel que décrit ci-dessus présente l'avantage majeur que la masse de la partie mobile comprenant la bobine 4 et le chariot 8 peut être maintenue très basse, limitant ainsi l'inertie du moteur et garantissant une accélération maximale du chariot 8.

L'usure d'un tel générateur de mouvement est également minimale, étant donné que les seuls frottements sont ceux des patins 81, 82 sur les rails 9.

Le mouvement du moteur voice coil est en revanche difficilement contrôlable. Il est en particulier difficile de limiter la vitesse et l'amplitude du mouvement du chariot avec précision et donc de l'arrêter sans rebond contre les butées 91, 92. L'utilisation d'un tel générateur de mouvement pour l'actionnement d'un contacteur de composants électroniques n'est rendue possible que par son association à un système de contrôle adapté, assurant une réduction progressive de la vitesse des lames flexibles 58, 68 du contacteur à l'approche du composant à tester et limitant surtout la force d'appui maximale des lames 58, 68 afin de ne pas endommager le composant à tester et d'obtenir un contact électrique de qualité suffisante pour exécuter le test dans de bonnes conditions.

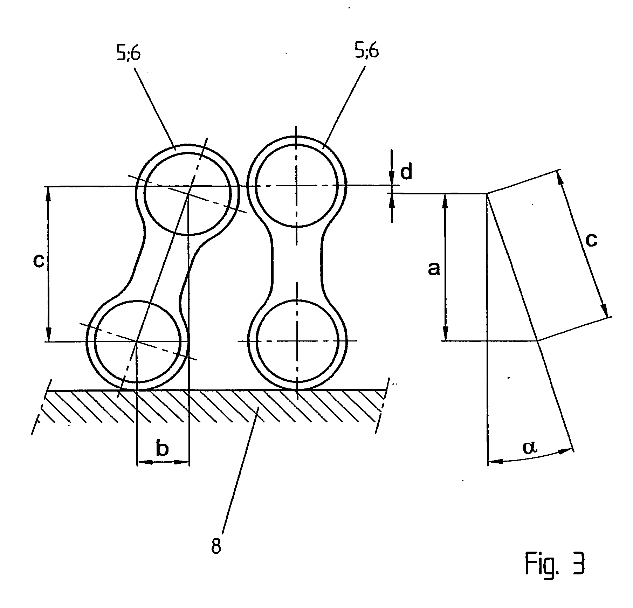

En se référant à la figure 3, dans la version préférentielle de l'invention, le système de contrôle comprend les deux biellettes 5, 6 attachées par leur axe inférieur au chariot 8. L'axe supérieur de la première biellette 5 est directement attaché à la partie inférieure du premier axe 55 guidé dans un guidage vertical à travers le châssis 1 du système. Le deuxième axe 62 de la deuxième biellette 6 est relié à un inverseur 7, constitué d'une pièce métallique rigide placée sensiblement horizontalement et pouvant tourner autour d'un axe en son milieu. L'autre extrémité de l'inverseur 7 est reliée à l'extrémité inférieure du deuxième axe 65, également guidé dans un guidage vertical à travers le châssis 1 du système.

Lorsque le chariot 8 est dans sa première position discrète, contre la butée 91, les biellettes 5, 6 forment un angle $\alpha$ par rapport à la verticale et leur deuxième axe est dans sa position la plus basse sur l'axe vertical. La mâchoire 56 est tirée vers le bas par l'axe 55 et la mâchoire 66 est poussée vers le haut par l'axe 65 relié à la deuxième biellette 6 par l'intermédiaire de l'inverseur 7. Le contacteur est ouvert, les composants peuvent être déplacés d'un poste de traitement au suivant. Dans la version préférentielle de l'invention illustrée ici à titre d'exemple, ces biellettes sont de même longueur et forment le même angle $\alpha$ avec la verticale, lorsque le contacteur est ouvert. Il serait également envisageable de contrôler les mouvements d'un transducteur électromécanique linéaire selon l'invention et actionner un contacteur à l'aide de biellettes de longueur et de positions différentes.

Lorsque le chariot 8 est dans sa deuxième position discrète, contre la deuxième butée 92, les biellettes 5, 6 sont en position sensiblement verticale. Leur deuxième axe est donc dans sa position la plus haute sur l'axe vertical. La mâchoire 56 est poussée vers le haut par l'axe 55 et la mâchoire 66 est tirée vers la bas par l'axe 65 à travers l'inverseur 7. Le contacteur est fermé, le test du composant peut être effectué.

Le fonctionnement des biellettes 5, 6 est illustré par le dessin de la figure 3. Lorsque le contacteur est ouvert, la biellette 5, 6 forme un angle $\alpha$ avec la verticale. L'axe inférieur de la biellette 5, 6, lié au chariot, se déplace horizontalement. L'axe supérieur de la biellette 5, 6, lié à un axe ou à l'inverseur, est guidé dans un mouvement vertical. Lorsque le chariot 8 se déplace vers sa deuxième position discrète pour fermer le contacteur, les biellettes 5, 6 sont amenées en position verticale. Le déplacement horizontal b du chariot induit un déplacement vertical d de l'axe supérieur de la biellette 5, 6. Les déplacements d et b sont liés par la formule :

$$d = b \cdot \left( \frac{1 - \cos\alpha}{\sin\alpha} \right)$$

Ainsi, si l'angle $\alpha$ reste faible, le déplacement vertical de l'axe supérieur de la biellette restera sensiblement inférieur au déplacement horizontal de son axe inférieur. La dérivation de la formule ci-dessus montre également que la vitesse de déplacement vertical diminue fortement à l'approche de la position verticale de la biellette 5, 6.

Cette relation entre le déplacement vertical et le déplacement horizontal présente plusieurs avantages.

Un premier avantage est la réduction de la vitesse des lames flexibles 58, 68 du contacteur à l'approche du point de contact avec le composant à tester. En cas de déplacement horizontal rapide du chariot autour de la position verticale de la biellette 5, 6, la vitesse verticale de l'axe supérieur de la biellette 5, 6 et par conséquent la vitesse des lames 58, 68 du contacteur est fortement réduite.

Un deuxième avantage est que les oscillations du chariot 8 autour de sa deuxième position discrète n'ont que peu d'influence sur la position des lames flexibles 58, 68.

Un troisième avantage est que la force du transducteur électromécanique linéaire est multipliée. Le maintien du contacteur en position fermée sur le composant à tester ne nécessite ainsi qu'une force minime de la part du transducteur.

Un avantage supplémentaire est que la position verticale de l'axe supérieur de la biellette 5, 6 connaissant un maximum absolu, l'écartement minimal des mâchoires 56, 66 du contacteur, et par conséquent la force de serrage ou d'appui du contacteur sur un type de composant particulier connaît également un maximum qui peut être déterminé avec précision. Un mouvement du chariot au-delà de sa deuxième position discrète idéale provoque une légère réouverture du contacteur, évitant ainsi d'endommager le composant à tester ou de contraindre excessivement les lames flexibles 58, 68. Le moment précis de fermeture du contacteur sur le composant à tester est toutefois déterminé à l'aide du deuxième capteur inductif 94 et l'instant précis de sa détection peut être réglé en agissant sur la deuxième vis 96.

Dans une variante du système d'actionnement selon l'invention, l'inverseur 7 est éliminé et l'axe supérieur de la deuxième biellette 6 est directement fixé à l'extrémité inférieure du deuxième axe 65. La fonction de l'inverseur est remplie, par exemple, par le positionnement vertical de la deuxième biellette 6 lorsque le chariot 8 est en appui contre la première butée 91. De cette manière, le déplacement du chariot vers sa deuxième position discrète provoque l'élévation du deuxième axe de la première biellette 5 et l'abaissement du deuxième axe de la deuxième biellette 6 qui se retrouve dans une position formant un angle $\alpha$ par rapport à la verticale, rapprochant ainsi les mâchoires 56 et 66 l'une de l'autre.

La version préférentielle de l'invention telle que décrite plus haut fait état, à titre d'illustration, d'un système d'actionnement de contacteur de composants électroniques dont le mouvement est généré par un moteur voice coil linéaire horizontal et sert à l'actionnement, à travers un système de contrôle, d'un contacteur se déplaçant sur l'axe vertical.

Le principe de l'invention pourrait toutefois également s'appliquer à tout générateur de mouvement électromécanique linéaire à plusieurs positions discrètes selon un axe quelconque et dont le mouvement, contrôlé par un système mécanique adéquat sert à actionner un contacteur selon tout autre axe linéairement indépendant du premier.

Dans une variante de l'invention, le transducteur électromécanique possède un nombre fini supérieur à deux de positions discrètes, imprimant ainsi au système d'actionnement un nombre correspondant de positions discrètes, par exemple pour contacter des composants dont la disposition des points de contact est plus complexe.

Le contacteur actionné par un tel système peut être de type différent de celui illustré ci-dessus à titre d'exemple. Il peut par exemple comporter une ou plusieurs paires de mâchoires actionnant des lames flexibles, une ou plusieurs paires de mâchoires dont seule la mâchoire supérieure ou inférieure est mobile, une ou plusieurs séries de lames métalliques flexibles entrant en contact avec le composant à tester par simple appui sur ses points de contact, ou toute combinaison de ces systèmes. Il peut également s'agir de contacteur pour composants à réseau en grille, par exemple de type « pin grid array » (PGA) ou « ball grid array » (BGA), le contacteur comprenant alors par exemple une plaque de contacts métalliques disposés en regard des contacts du composant qui est appliquée contre sa surface inférieure.

Ces différents types de contacteurs nécessitant une adaptation du système d'actionnement selon l'invention, celui-ci peut par exemple ne comprendre qu'une seule biellette pour l'activation d'une seule série de contacts, ou au contraire une quantité supérieure de biellettes ayant par exemple des longueurs et des angles différents par rapport à la verticale, afin d'imprimer aux différents éléments du contacteur des mouvement ayant des vitesses et des amplitudes différentes.

Dans une variante du système d'actionnement selon l'invention, les biellettes peuvent être avantageusement remplacées par un ensemble de cames.

**Revendications**

1. Système d'actionnement de contacteur de composants semi-conducteurs comportant:

   un contacteur (58, 68),
   un générateur de mouvement linéaire constitué par un transducteur électromécanique linéaire (2, 3, 4)
   un système de contrôle de la force de contact dudit contacteur sur ledit composant semi-conducteur,

   **caractérisé en ce que**
   ledit générateur de mouvement linéaire permet de fermer ou d'ouvrir ledit contacteur,
   ledit contacteur comporte deux séries de lames métalliques élastiques arrangées par paires pour enserrer en position fermée une pluralité de broches du composant semi-conducteur à tester,

ledit transducteur électromécanique linéaire (2, 3, 4) possédant au moins deux positions discrètes.

**2.** Système d'actionnement selon la revendication 1, dans lequel ledit transducteur électromécanique linéaire est un moteur voice coil.

**3.** Système d'actionnement selon la revendication 2, dans lequel ledit moteur voice coil comporte une bobine électrique mobile (4) placée entre deux blocs d'aimants permanents fixes (2, 3).

**4.** Système d'actionnement selon la revendication 3, dans lequel ladite bobine électrique mobile (4) est guidée selon un axe sensiblement parallèle au plan médiateur du segment le plus court entre lesdits deux blocs d'aimants permanents (2, 3).

**5.** Système d'actionnement selon l'une des revendications 3 ou 4, dans lequel ladite bobine électrique mobile (4) est montée sur au moins un patin (81, 82) guidé sur au moins un rail linéaire (9).

**6.** Système d'actionnement selon l'une des revendications 3 à 5, dans lequel l'amplitude du mouvement de ladite bobine électrique mobile (4) est limitée de chaque côté par des butées (91, 92).

**7.** Système d'actionnement selon l'une des revendications 1 à 6, dans lequel ledit mécanisme de limitation de la force de contact comporte au moins une biellette (5, 6).

**8.** Système d'actionnement selon la revendication 7, dans lequel une première extrémité de ladite au moins une biellette (5, 6) est solidaire de la partie mobile (4, 8) dudit générateur de mouvement.

**9.** Système d'actionnement selon l'une des revendications 7 ou 8, dans lequel la deuxième extrémité de ladite au moins une biellette (5, 6) est solidaire de la première mâchoire (56) du contacteur de composants semi-conducteurs.

**10.** Système d'actionnement selon l'une des revendications 7 à 9, dans lequel l'axe de déplacement de la deuxième extrémité de ladite au moins une biellette (5, 6) est guidée selon un axe linéairement indépendant de l'axe de déplacement de la première extrémité de ladite au moins une biellette (5, 6).

**11.** Système d'actionnement selon l'une des revendications 7 à 10 comportant deux biellettes (5, 6).

**12.** Système d'actionnement selon la revendication 11, dans lequel chacune desdites deux biellettes (5, 6) actionne une mâchoire (56, 66) du contacteur de composants semi-conducteurs.

**13.** Système d'actionnement selon l'une des revendications 11 ou 12 comportant un inverseur (7) attaché à la deuxième extrémité de la deuxième biellette (6).

**14.** Cycle de commande d'un système d'actionnement de contacteur selon l'une des revendications 1 à 13 comprenant :

la génération d'un courant électrique provoquant la fermeture du contacteur,
la génération d'un courant électrique de plus faible intensité maintenant le contacteur en position fermée,
la génération d'un courant de direction opposée à la direction du courant généré précédemment provoquant l'ouverture du contacteur,
la génération d'un courant électrique de plus faible intensité maintenant le contacteur en position ouverte.

**Claims**

**1.** System for actuating a contactor of semi-conductor components comprising
a contactor (58, 68),
a linear movement generator constituted by a linear electromechanical transducer (2, 3, 4),
a contact force control system of said contactor on said semi-conductor component,
**characterized in that**
said linear movement generator allows said contactor to be closed or opened,
said contactor comprises two series of elastic metallic blades arranged in pairs for clasping in closed position a plurality of pins of the semi-conductor component to be tested,
said linear electromechanical transducer (2, 3, 4) having at least two discrete positions.

**2.** Actuating system according to claim 1, wherein said linear electromechanical transducer is a voice coil motor.

**3.** Actuating system according to claim 2, wherein said voice coil motor comprises a mobile electric coil (4) placed between two fixed blocks of permanent magnets (2, 3).

**4.** Actuating system according to claim 3, wherein said mobile electric coil (4) is guided along an axis more or less parallel to the median-plane of the shortest segment between said two blocs of permanent magnets (2, 3).

**5.** Actuating system according to one of the claims 3 or 4, wherein said mobile electric coil (84) is mounted on at least one runner (81, 82) guided on at least one linear rail (9).

6. Actuating system according to one of the claims 3 to 5, wherein the amplitude of movement of said mobile electric coil (4) is limited on each side by stops (91, 92).

7. Actuating system according to one of the claims 1 to 6, wherein said mechanism for limiting the contact force comprises at least one connecting rod (5, 6).

8. Actuating system according to claim 7, wherein a first extremity of said at least one connecting rod (5, 6) is united with the mobile part (4, 8) of said movement generator.

9. Actuating system according to one of the claims 7 or 8, wherein the second extremity of said at least one connecting rod (5, 6) is united with the first jaw (56) of the contactor of semi-conductor components.

10. Actuating system according to one of the claims 7 to 9, wherein the displacement axis of the second extremity of said at least one connecting rod (5, 6) is guided along an axis linearly independent from the displacement axis of the first extremity of said at least one connecting rod (5, 6).

11. Actuating system according to one of the claims 7 to 10, comprising two connecting rods (5, 6).

12. Actuating system according to claim 11, wherein each of said two connecting rods (5, 6) actuates a jaw (56, 66) of the contactor of semi-conductor components.

13. Actuating system according to one of the claims 11 or 12, comprising a reversing lever (7) fastened to the second extremity of the second connecting rod (6).

14. Control cycle of a contactor actuating system according to one of the claims 1 to 13, comprising:

> generating an electric current causing the contactor to close,
> generating an electric current of lower intensity holding the contactor in closed position,
> generating a current of opposite direction to the direction of the current previously generated causing the contactor to open,
> generating an electric current of lower intensity holding the contactor in open position.

**Patentansprüche**

1. System zur Betätigung eines Kontaktglieds von Halbleiterkomponenten, mit:

> einem Kontaktglied (58, 68),
> einem Erzeuger linearer Bewegung, bestehend aus einem linearen elektromechanischen Wandler (2, 3, 4),
> einem System zur Kontrolle der Kontaktkraft des besagten Kontaktglieds auf die besagte Halbleiterkomponente,

**dadurch gekennzeichnet, dass**
der besagte Erzeuger linearer Bewegung es erlaubt, das besagte Kontaktglied zu schliessen oder zu öffnen,
das besagte Kontaktglied zwei Serien von in Paaren angeordneten metallischen elastischen Klingen umfasst, um in geschlossener Position eine Vielzahl von Stiften der zu testenden Halbleiterkomponente zu greifen,
wobei der besagte lineare elektromechanische Wandler (2, 3, 4) mindestens zwei diskrete Positionen besitzt.

2. Betätigungssystem gemäss Anspruch 1, worin der besagte lineare elektromechanische Wandler ein Voice Coil Motor ist.

3. Betätigungssystem gemäss Anspruch 2, worin der besagte Voice Coil Motor eine mobile elektrische Spule (4) umfasst, die zwischen zwei Blöcken von permanenten Magneten (2, 3) angeordnet ist.

4. Betätigungssystem gemäss Anspruch 3, worin die besagte mobile elektrische Spule (4) entlang einer Achse geführt wird, die einigermassen parallel zur Medianebene des kürzesten Segments zwischen den besagten beiden Blöcken von permanenten Magneten (2, 3) ist.

5. Betätigungssystem gemäss einem der Ansprüche 3 oder 4, worin die besagte mobile elektrische Spule (4) auf mindestens einem Kontaktschuh (81, 82) montiert ist, der auf mindestens einem linearen Gleis (9) geführt ist.

6. Betätigungssystem gemäss einem der Ansprüche 3 bis 5, worin die Amplitude der Bewegung der besagten mobilen elektrischen Spule (4) auf jeder Seite durch Stopper (91, 92) eingeschränkt ist.

7. Betätigungssystem gemäss einem der Ansprüche 1 bis 6, worin der besagte Mechanismus zur Einschränkung der Kontaktkraft mindestens einen Schwingarm (5, 6) umfasst.

8. Betätigungssystem gemäss Anspruch 7, worin ein erstes Ende des besagten mindestens einen Schwingarms (5, 6) mit dem mobilen Teil (4, 8) des besagten Bewegungserzeugers fest verbunden ist.

9. Betätigungssystem gemäss einem der Ansprüche 7 oder 8, worin das zweite Ende des besagten mindestens einen Schwingarms (5, 6) mit der ersten Backe (56) des Kontaktglieds von Halbleiterkomponenten fest verbunden ist.

10. Betätigungssystem gemäss einem der Ansprüche 7 bis 9, worin die Bewegungsachse des zweiten Endes des besagten mindestens einen Schwingarms (5, 6) entlang einer Achse geführt wird, die linear unabhängig zur Bewegungsachse des ersten Endes des besagten mindestens einen Schwingarms (5, 6) ist.

11. Betätigungssystem gemäss einem der Ansprüche 7 bis 10, mit zwei Schwingarmen (5, 6).

12. Betätigungssystem gemäss Anspruch 11, worin jeder der beiden Schwingarme (5, 6) eine Backe (56, 66) des Kontaktglieds von Halbleiterkomponenten betätigt.

13. Betätigungssystem gemäss einem der Ansprüche 11 oder 12, mit einem Inverter (7), der mit dem zweiten Ende des zweiten Schwingarms (6) verbunden ist.

14. Kontrollzyklus eines Systems zur Betätigung eines Kontaktglieds gemäss einem der Ansprüche 1 bis 13, mit:

Erzeugen eines elektrischen Stroms, was das Schliessen des Kontaktglieds verursacht,
Erzeugen eines elektrischen Stroms schwächerer Intensität, was das Kontaktglied in geschlossener Position hält,
Erzeugen eines Stroms in entgegen gesetzter Richtung zur Richtung des vorher erzeugten Stroms, was das Öffnen des Kontaktglieds verursacht,
Erzeugen eines elektrischen Stroms schwächerer Intensität, was das Kontaktglied in offener Position hält.

Fig. 1

EP 1 476 761 B1

9

Fig. 2a

Fig. 2b

5;6                    5;6

d

c                      a        c

b

8                               α

Fig. 3

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 5850146 A
- US 4956923 A
- US 6344751 B